Europäisches Patentamt

European Patent Office

Office européen des brevets

(19)

(11) Publication number: **0 218 413 B1**

## EUROPEAN PATENT SPECIFICATION

(12)

(45) Date of publication of patent specification: **08.07.92** (51) Int. Cl.⁵: **G11B 20/18**, H03M 13/00

(21) Application number: **86307326.8**

(22) Date of filing: **24.09.86**

(54) **System and method for correcting errors in coded data recorded in blocks and sub-blocks.**

(30) Priority: **27.09.85 US 781449**

(43) Date of publication of application:
**15.04.87 Bulletin 87/16**

(45) Publication of the grant of the patent:
**08.07.92 Bulletin 92/28**

(84) Designated Contracting States:
**DE FR GB IT**

(56) References cited:
**EP-A- 0 112 988       EP-A- 0 114 938**
**EP-A- 0 117 287       EP-A- 0 140 381**
**GB-A- 2 061 575       GB-A- 2 076 569**

**IBM TECHNICAL DISCLOSURE BULLETIN, vol. 17, no. 2, July 1974, pages 473-475, New York, US; A.M. PATEL: "Coding scheme for multiple sections error-correction"**

**IBM JOURNAL OF RESEARCH & DEVELOPMENT, vol. 24, no. 1, January 1980, pages 32-42, New York, US; A.M. PATEL: "Error recovery scheme for the IBM 3850 mass storage system"**

(73) Proprietor: **International Business Machines Corporation**
**Old Orchard Road**
**Armonk, N.Y. 10504(US)**

(72) Inventor: **Patel, Arvind Motibhai**
**6583 San Ignacio Avenue**
**San Jose California 95119(US)**

(74) Representative: **Atchley, Martin John Waldegrave**
**IBM United Kingdom Limited Intellectual Property Department Hursley Park**
**Winchester Hampshire SO21 2JN(GB)**

(73) Proprietor: **International Business Machines Corporation**
**Old Orchard Road**
**Armonk, N.Y. 10504(US)**

(72) Inventor: **Patel, Arvind Motibhai**
**6583 San Ignacio Avenue**
**San Jose California 95119(US)**

(74) Representative: **Atchley, Martin John Waldegrave**
**IBM United Kingdom Limited Intellectual Property Department Hursley Park**
**Winchester Hampshire SO21 2JN(GB)**

EP 0 218 413 B1

EP 0 218 413 B1

**Description**

The present invention relates to a system and a method for correcting errors in coded data recorded on a record medium in blocks and sub-blocks with error check bytes recorded with the data bytes. The invention has a particular application in correcting errors in coded data recorded on a diskfile.

The prior art describes various systems and methods for correcting errors in coded data recorded in multi-bit bytes in a suitable record medium, such as a disk. US-A-4,525,838 is pertinent, includes other relevant references, and is hereby incorporated by reference as if fully set forth herein.

Present day disk file manufacturers employ a number of different approaches to minimise the number of errors that may occur during the process of reading out coded data recorded on a disk. Most disk file media undergo a thorough surface analysis test to identify defective areas before the disk is incorporated into the drive. Those disks having defects above a certain predetermined criteria are rejected.

In addition, subsystems are provided in many disk file devices which, based on defect data stored on a disk, cause the drive to avoid a bad track, a bad sector, or a defective area of a disk track during operation. Bad areas of the medium are simply skipped during the recording of data on the medium. Other subsystems cause the read out device to re-read the data when an error is detected. This re-reading operation is performed under slightly different operating conditions each time, such as offsetting the transducer from the centre of the record track or increasing the gain of the read amplifier until, hopefully, the error is corrected during the re-reading process.

Since addition of an error-correcting subsystem adversely impacts overall system performance, it is important to minimise the number of errors that have to be corrected and the time it takes to correct them. In addition, the more errors which must be corrected, the more otherwise usable storage capacity is wasted.

Typically, subsystems which correct only single errors are used in current disk files. A single error, by definition, may include a burst-type error in which a group of contiguous bit positions are affected. However, two separate burst errors, or even widely spaced single bit errors, cannot be corrected by such single error correcting subsystems.

It is well known that all the different error patterns which occur in one byte of a multibyte codeword are correctable using a reasonable amount of redundancy. It has also been recognised that by interleaving codewords, a burst error which extends longer than one byte may be corrected.

It is also known that a multibyte, error correcting system may be provided in accordance with the teaching of US-A-4,494,234.

One of the main reasons multibyte error correcting systems have not been readily adopted for use in disk files is the constraints imposed on block size or codeword by various error correcting codes in use today. A codeword is typically limited to $2^b$ bytes where b is the number of bit positions in the byte configuration adopted for the system. Where the byte consists of eight bits, which is substantially the present standard in the data processing industry, the codeword is usually limited to 255 bytes. It is further recognised that for each byte error to be corrected in a codeword of 255 bytes, two check bytes must be associated with the codeword for each byte error. Thus, if the error correcting code (ECC) is designed to correct five byte errors in each codeword, then ten check byte positions must be allocated out of the 255 byte positions. Obviously, where redundancy becomes so high, the overall useful storage capacity of the disk file is severely restricted.

Besides adversely affecting useful storage capacity, the relatively small block size also imposes many undesirable constraints in the design of the data format this is used on the track. Conventional coding techniques, such as multiple error correcting Reed-Solomon or BCH codes discussed in the prior art, while very efficient in terms of mathematical redundancy, impose algebraic constraints on the size of the codeword for a given choice of byte size. Thus, in a practical application of 8-bit bytes in the presence of high error rates, the redundancy is often still unacceptable.

A two-level, multibyte error correcting system for correcting errors occurring in more than one byte is described in US-A-4,525,838. In that system the coded data bytes are grouped in blocks, each of which includes at least one sub-block. However, for that system, if the number of errors occurring in any one sub-block exceeds the error-correction capability at the sub-block level, the codeword may be miscorrected at the sub-block level. When the miscorrection is detected at the block level, the miscorrected sub-block is restored to its original condition before such errors are corrected at the block level. Moreover, that system will not make corrections as described unless all other sub-blocks are error free or the number of errors occurring in all other sub-blocks is correspondingly reduced to below the sub-block level error-correction capability by the same amount as the number of excess errors in one sub-block.

EP-A-0 117 287 describes an error correcting system for correcting errors in coded data recorded on a record medium in blocks of data bytes, in which each block includes at least one sub-block of data bytes.

2

In this system the correction is performed at the sub-block level. Any sub-block miscorrection is detected at block level. This is corrected at block level after returning the miscorrected sub-block and block syndromes to their original condition.

EP-A-0 140 381 also describes an error correcting system for correcting errors in coded data recorded on a record medium in two levels. In this system errors are detected at the first level whether or not the number of errors is such that they can be corrected. If not, the error correction does not take place at the first level.

The object of the present invention is to provide an improved system and method for correcting errors in coded data recorded on a record medium in blocks of data bytes.

The present invention relates to an error correcting system for correcting errors in coded data recorded on a record medium in blocks of data bytes, in which each block comprises at least one sub-block of data bytes and at least one sub-block error check byte, and at least one block error check byte. The system is of the type which comprises error syndrome byte generating means, responsive to the error check bytes recorded in each sub-block, for generating, during read out of the data bytes and error check bytes in each sub-block, error syndrome bytes, and error correcting means, responsive to the error syndrome bytes, for correcting errors in the data bytes read out from each of the sub-blocks.

The system also comprises

first error syndrome byte generating means for generating sub-block error syndrome bytes, corresponding to the check bytes associated with each sub-block,

first error syndrome processing circuitry, responsive to the sub-block error syndrome bytes, to detect and correct a predetermined number of errors in the data bytes in each sub-block and to detect but not correct another predetermined number of errors in the data bytes in each sub-block,

block error check byte generating means for generating block error check bytes for each block,

second error syndrome byte generating means for generating block error syndrome bytes, corresponding to the error check bytes in each block and the block error check bytes, and

second error syndrome processing circuitry, responsive to the additional block error syndrome bytes, to correct additional errors in the data bytes in each block.

A system according to the invention is characterised in that

each sub-block comprises up to $2^b$ b-bit data bytes, where b is any positive integer, and $2t_1 + c$ error check bytes where $t_1$ and c are positive integers such that $t_1 \geq, c \geq 1$,

each block comprises up to $2t_2$ b-bit error check bytes where $t_2$ is a positive integer such that $t_2 \geq t_1$,

the first error syndrome byte generating means generates, for each sub-block, $2t_1 + c$ error syndrome bytes, each containing b bits, corresponding to the $2t_1 + c$ error check bytes in each sub-block,

the first error syndrome processing circuitry detects and corrects up to $t_1$ errors and detects but does not correct up to $t_1 + c$ errors in each sub-block, and

the second error syndrome generating means generates, for each block, $2t_2$ block error syndrome bytes.

The invention also relates to a method of correcting errors in coded data recorded on a record medium in blocks of data bytes utilising a system as above as defined in appended claim 7.

The multibyte error-correcting subsystem according to the present invention employs a two level code structure having improved capability and simplified procedure. The structure provides at least four major advantages. First, the constraint on the size of the codeword is eliminated. Second, the decoding strategy permits "on-the-fly" correction of multibyte errors at the sub-block level and additional reserve error correction capability at the block level. Third, when the number of errors occurring in one sub-block exceeds the sub-block level error correcting capability by a selectable number of additional errors, c, the codeword is corrected at the block-level, without first being miscorrected at the sub-block level. Finally, second level (i.e., block level) correction of excessive errors in one sub-block does not require corresponding reduction in the number of correctable errors in all other sub-blocks, so long as the excessive errors do not exceed c.

In addition to the above-listed advantages of an error correction system in accordance with the present invention, if the number of additional errors in any one sub-block exceeds c, the error correcting system of is still capable of correcting those errors. Such additional excessive errors may cause codeword miscorrection at the first level and are detected and corrected at the second level in the same manner as described in US-A-4,525,838.

In the two level coding structure of an error correction system in accordance with the present invention, the coded data is formatted on a disk track into n sub-blocks within each block, each sub-block comprising a primary codeword with m data bytes and $r_1$ error check bytes. Of course, a sub-block may also comprise two or more interleaved primary codewords of the same byte composition of data and check bytes.

3

At the first level (i.e., sub-block level), the coding structure is designed so that the error correction system will correct up to $t_1$ errors and will detect up to $t_1$ + c errors in each sub-block of the primary codeword. At the second level (i.e., block level), the system will correct up to $t_2$ errors in any one of the sub-blocks.

The block level check bytes are shared by all the sub-blocks in a block. If there are any errors in block-level check bytes, then the second level error correction capability, $t_2$, is reduced by an amount corresponding to the number of block level check byte errors.

At the first level, the system in accordance with the present invention provides on-the-fly correction of $t_1$ errors in each sub-block and identifies any sub-block having more than $t_1$ errors. Correction of a sub-block having more than $t_1$ errors is deferred to the end of the record (i.e., block level), and can be performed on-the-fly or by any other known software or hardware method.

An error correction system according to the present invention enhances the error correcting capability of previously known two-level multibyte correcting systems by adaptive utilisation of check bytes at both levels. The system can concentrate the two level error correcting capability on one sub-block having more than $t_1$ errors while at the same time providing the capability for correcting $t_1$ errors in any or all other sub-blocks in a block consisting of several sub-blocks.

In order that the invention may be more readily understood an embodiment will now be described with reference to the accompanying drawings, in which:

Fig. 1 is a diagrammatic illustration showing the format of coded data on a disk file track constructed according to the principles of an error correction system according to the present invention,

Fig. 2 is a block diagram of a feedback shift register for producing two of three sub-block level check bytes for the coded data format illustrated in Fig. 1,

Fig. 3 is a block diagram, in greater detail, of the logic for the feedback shift register shown schematically in Fig. 2,

Fig. 4 is a block diagram of the logic employed for generating the third sub-block level check byte for the coded data format illustrated in Fig. 1,

Fig. 5 illustrates a matrix $T^3$ employed in the logic operations of the devices of Figs. 3 and 4, and a block diagram of the logic of the matrix $T^3$,

Fig. 6 is a block diagram of the specific logic employed in an error correction system according to the present invention for generating one block level check byte,

Fig. 7 is a block diagram of the first and second level portions of an error correction system according to the present invention for correcting single errors in the sub-blocks by processing sub-block error syndromes and for correcting two errors in a sub-block by processing sub-block and block error syndromes,

Fig. 8 is a block diagram of a sub-block level decoder in an error correction system according to the principles of the present invention,

Fig. 9A is a $T^{-1}$ matrix multiplier employed in the decoder of Fig. 8,

Fig. 9B is a $T^{-2}$ matrix multiplier employed in the decoder of Fig. 8, and

Fig. 9C is a $T^{-3}$ matrix multiplier employed in the decoder of Fig. 8.

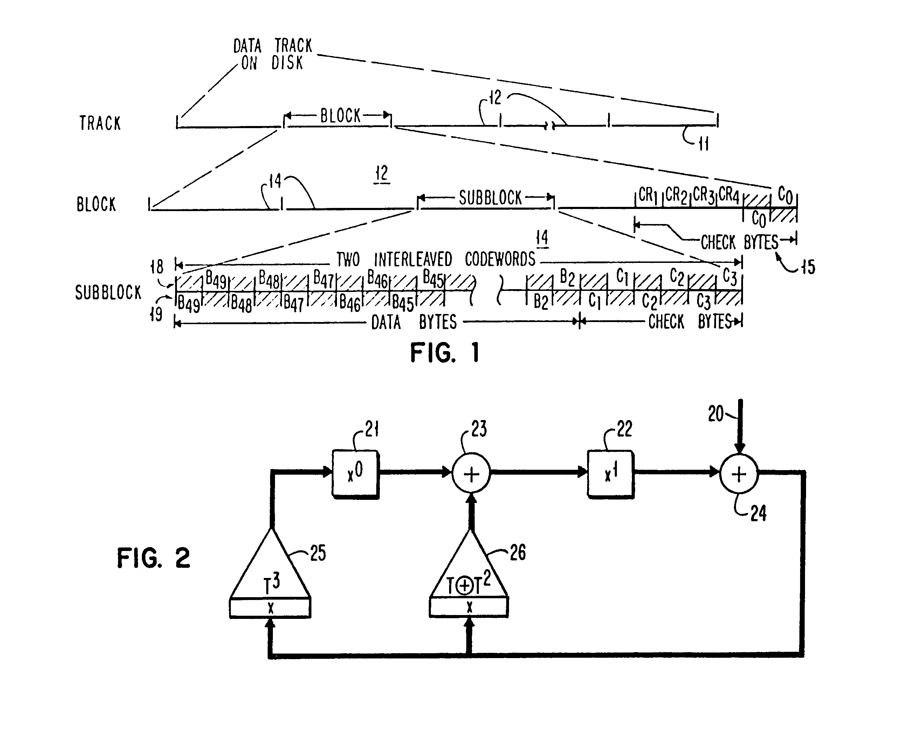

In Fig. 1 there is illustrated coded data recorded along a disk track in a two level code constructed according to the principles of an error correction system according to the present invention. The coded data is recorded in blocks of bytes with each block being sub-divided into sub-blocks. The error correction capability of such a system is designed to correct up to two errors in any one of the sub-blocks and up to one error in any or all remaining sub-blocks in each block. An error is defined as any pattern of eight bits in one byte position of the block which is not the correct pattern. The error correction system is applicable for correcting any number of errors in various combinations in the sub-blocks of the block. This general case is described elsewhere in this specification.

As shown in Fig. 1, data recorded along track 11 is formatted into a plurality of fixed or variable length blocks 12, each of which is divided into a predetermined plurality of sub-blocks 14. A block error check byte area 15 is associated with each block. This area, as shown and described in more detail below, includes four check byte positions for data integrity checking and two check byte positions for second-level error correction.

In the configuration of Fig. 1, a codeword comprises 48 data byte positions and three check byte positions. Each sub-block has two interleaved codewords. Each block 12 comprises: n sub-blocks (n = 4), each having 96 data byte positions and three pairs of sub-block check bytes, $C_1$, $C_2$ and $C_3$; four check bytes, $CR_1$-$CR_4$, for data integrity checking; and two check bytes, $C_0$, for second level correction.

The data integrity check bytes, $CR_1$-$CR_4$, appended to the end of each block are CRC check bytes which provide data integrity check after ECC correction. These check bytes, how they are determined and produced, form no part of the present invention.

The preferred embodiment of an error correction system according to the present invention is based on codes for symbols in Galois Fields ($2^8$), or GF ($2^8$). The primary codeword in each sub-block comprises m data bytes (m = 48) designated $B_2$, $B_3...B_{m+1}$, and three check bytes designated $C_1$, $C_2$ and $C_3$. Check bytes $C_1$ and $C_2$ identically correspond to $B_1$ and $B_0$ and satisfy the following two modulo-2 matrix equations:

$$B_0 \oplus TB_1 \oplus T^2B_2 \oplus...\oplus T^{m+1}B_{m+1} = 0 \qquad (1)$$

$$B_0 \oplus T^2B_1 \oplus T^4B_2 \oplus...\oplus T^{2(m+1)}B_{m+1} = 0 \qquad (2)$$

In equations (1) and (2), the $\oplus$ represents a modulo-2 summation operation, $B_i$ is an 8-bit byte as a column vector, i is a byte position in the codeword and has a value from 0 to m + 1, where m + 1 is equal to or less than 254 or ($2^8$-2). T is a companion matrix of a primitive polynomial of degree 8. The symbol $T^i$ represents T multiplied by itself i times. It is assumed that the following T matrix is embodied in the preferred embodiment:

$$
T = \begin{bmatrix}
0 & 0 & 0 & 0 & 0 & 0 & 0 & 1 \\
1 & 0 & 0 & 0 & 0 & 0 & 0 & 0 \\
0 & 1 & 0 & 0 & 0 & 0 & 0 & 0 \\
0 & 0 & 1 & 0 & 0 & 0 & 0 & 1 \\
0 & 0 & 0 & 1 & 0 & 0 & 0 & 0 \\
0 & 0 & 0 & 0 & 1 & 0 & 0 & 1 \\
0 & 0 & 0 & 0 & 0 & 1 & 0 & 0 \\
0 & 0 & 0 & 0 & 0 & 0 & 1 & 1
\end{bmatrix} \qquad (3)
$$

The code given by equations (1) and (2) is single-symbol-correcting Reed-Solomon or BCH code readily known from the prior art. The 8-bit column vectors correspond to elements of GF ($2^8$), and multiplication by matrix $T^i$ corresponds to the multiplication by the Galois field element $\alpha^i$ where $\alpha$ is a primitive element represented by the first column of the matrix T.

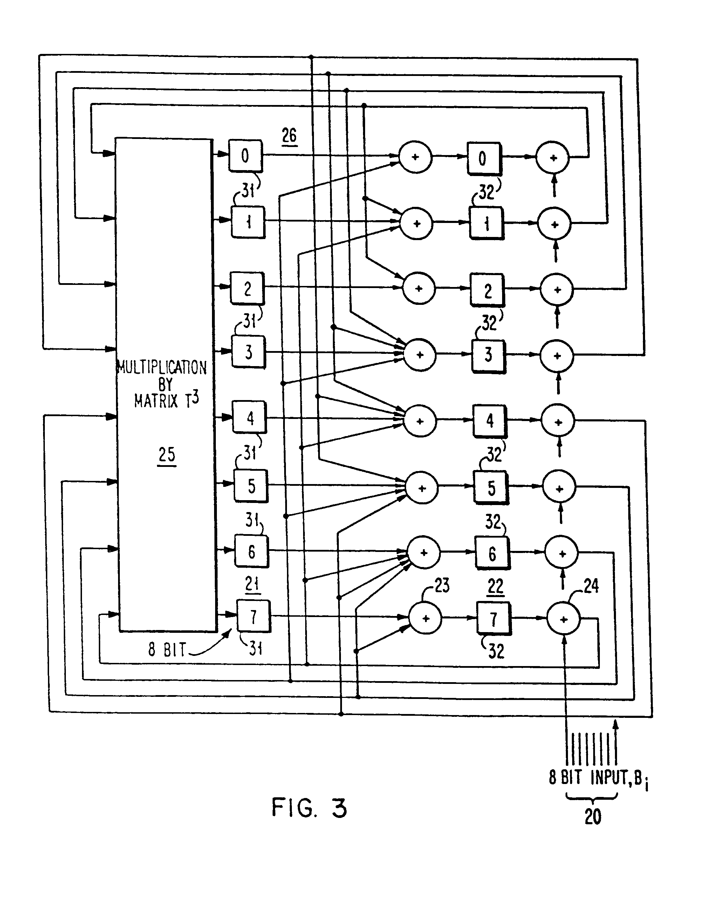

The encoder for generating the check bytes $C_1$ and $C_2$ for each word in each sub-block is shown in Figs. 2 and 3. The encoder functions to perform modulo g (x) operations where g (x) is a polynomial with root $\alpha$ and $\alpha^2$. The specific generator polynomial is:

$$g (x) = (T + x) (T^2 + x) = T^3x^0 + (T + T^2)x^1 + x^2.$$

Check bytes $C_1$ and $C_2$, which correspond to $B_0$ and $B_1$, respectively, for one codeword, are developed by supplying data bytes $B_{m+1}$ through $B_2$ to input 20. Block 21 and block 22 function to store an 8-bit field element. Blocks 23 and 24 function to add two 8-bit field elements modulo 2, while blocks 25 and 26 function as matrix multipliers to multiply an 8-bit field element by a specific matrix. Initially, blocks 21 and 22 are set to zero and the data bytes are clocked into the encoder at input 20. At the end of the operation, blocks 21 and 22 of the encoder contain check bytes $C_1$ and $C_2$, respectively.

Check byte $C_3$ is given by the modulo 2 matrix equation:

$$C_3 = \sum_{i=0}^{m+1} T^{3i}B_i \qquad (4)$$

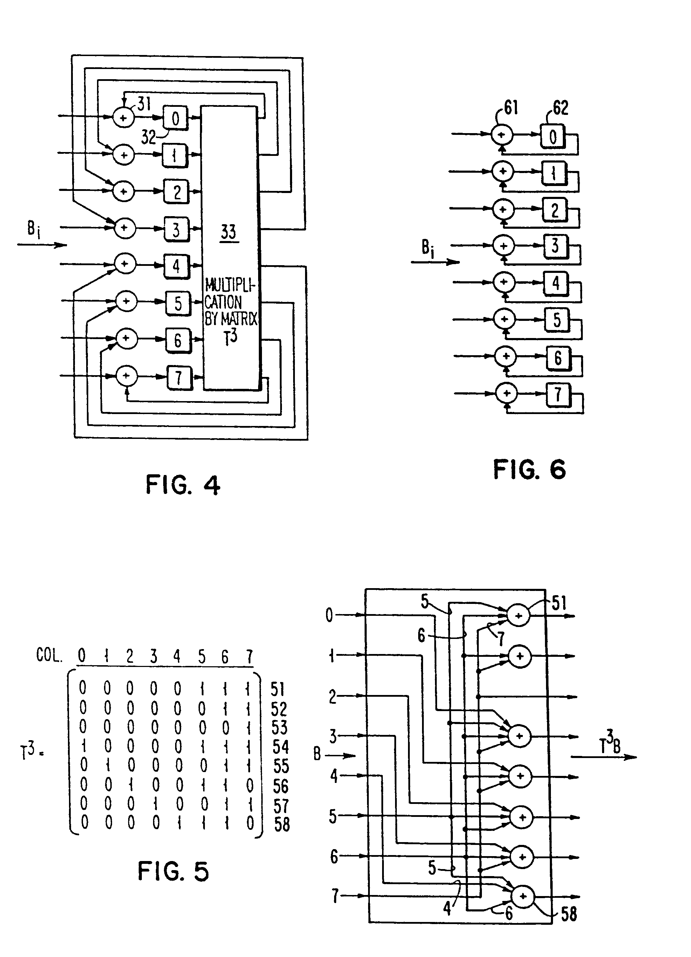

The computation of $C_3$, unlike the computations of $C_1$ and $C_2$, is performed separately by means of a shift register and matrix multiplier as shown in Fig. 4. Initially, the shift register is set to all zeroes and the ordered sequence of sub-block bytes, starting with $B_{m+1}$ through $B_0$, is entered into the register in m + 2 successive shifts. At the end of this operation, the contents of register 32 corresponds to the value of $C_3$. Element 31 of Fig. 3 is an exclusive-OR circuit, and element 32 is one stage of a shift register. Element 33 is a matrix multiplier of the type shown in Fig. 5.

The details of the matrix multiplier for $T^3$, represented by block 25 in Figs. 2 and 3 and block 33 of Fig. 4 are shown in Fig. 5. Selected bit positions of 8-bit vector, B, are combined modulo 2 in blocks 51 through 58. The bit positions selected for inputs to blocks 51 and 58 are determined from matrix $T^3$ as shown in Fig. 5A. The top row determines the input for block 51, while the bottom row determines the input for block 58. A binary "1" digit in a column signifies an input from the corresponding bit position of the input vector B. Hence, block 51 receives input from bit positions 5, 6 and 7, while block 58 receives input from bit positions 4, 5 and 6, corresponding respectively to the columns containing ones in the matrix $T^3$. The inputs to other blocks are arranged in like manner.

Each block 12 comprises any number of sub-blocks, n, with an additional check byte, $C_0$, appended at the end. $C_0$ is computed for each sub-block and is then accumulated modulo 2 over all sub-blocks, as specified by the following modulo-2 matrix equation:

$$C_0 = \sum_{subbk=1}^{n} \left( \sum_{i=0}^{m+1} B_i \right)_{subbk} \tag{5}$$

$C_0$ encoding is performed by a separate shift register encoder, as schematically shown in Fig. 6. The encoder for $C_0$ is functionally equivalent to a parity generator for each bit position of the input vectors. Element 61 represents an exclusive-OR circuit, while element 62 represents one stage of a register.

Initially, shift register 62 is set to zero, and bytes $B_i$ of the first sub-block are supplied to each encoder starting with $B_{m+1}$ through $B_0$ in $(m+2)$ successive shifts. At the end of the shift sequence, the contents of register 62 corresponds to the value of $C_0$ for the first sub-block. $C_0$ for each successive sub-block of the block is accumulated modulo 2 over all of the sub-blocks in a suitable buffer.

If there is only one sub-block, the four check bytes $C_0$, $C_1$, $C_2$ and $C_3$ corresponding to equations (1), (2), (4) and (5) comprise a code that is obtained by extending a two symbol correcting BCH code such as that described by J. K. Wolf in an article in the BELL SYSTEM TECHNICAL JOURNAL, No. 48, pages 2408 through 2424, published in 1969 and entitled "Adding Two Information Symbols to Certain Non-binary BCH Codes and Some Applications". In the error correction system being described herein, the block level codeword can be viewed as a modulo 2 super-position of the four sub-block codewords. Therefore, a two symbol error in such a super-positioned codeword is correctable.

In the embodiment shown, the first three of the four block check bytes are developed by merely accumulating sub-block check bytes $C_1$, $C_2$, $C_3$ which need not be recorded at the block level. The four block check bytes required to correct two one byte errors in any sub-block may be obtained independently of the sub-block check bytes $C_1$, $C_2$ and $C_3$. The four matrices $T^a$, $T^{a+1}$, $T^{a+2}$, $T^{a+3}$ which are selected for generating the four block check bytes, however, must be adjacent powers a, $a+1$, $a+2$, and $a+3$ of the matrix T in the $GF(2^8)$ field. The preferred embodiment of the error correction system saves redundancy and hardware by making use of the accumulated sub-block check bytes $C_1$, $C_2$ and $C_3$ for each word of the block.

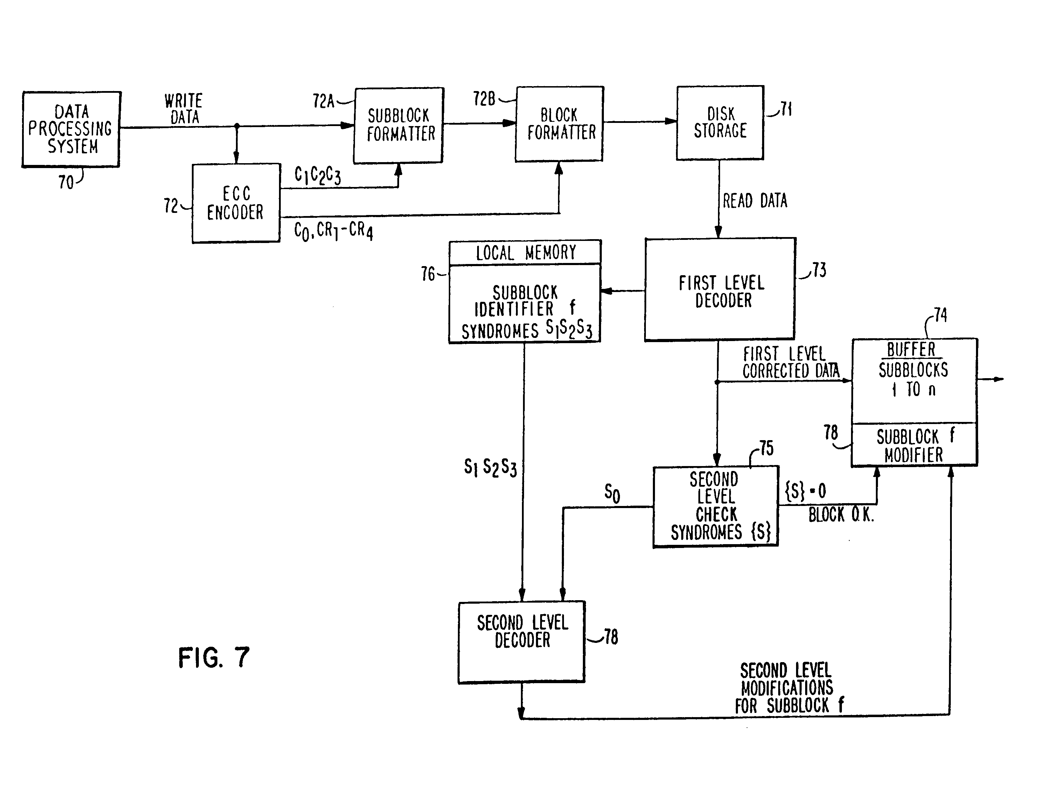

Fig. 7 illustrates the operation of an error correction system according to the present invention. Referring now to Fig. 7, data from a data processing system 70 is sent to a disk file 71 for storage on a track on which the coded data is formatted as shown in Fig. 1. In the transfer of this data, three sets of check bytes $C_1$, $C_2$ and $C_3$ are developed for each sub-block by ECC encoder 72 as described above. Similarly, block check byte $C_0$ is also developed by encoder 72. The sub-block formatter 72A appends check bytes $C_1$, $C_2$ and $C_3$ to each corresponding sub-block. Similarly, block formatter 72B appends block check byte $C_0$ (as well as data integrity check bytes, $CR_1$ - $CR_4$) at the end of the block. The formatted data is then recorded on disk storage 71.

In the readout or readback process, the readout data is checked by the coding equations (1), (2), (4) and (5) in order to develop the syndromes of error in the conventional manner. In particular, the sub-block check bytes $C_1$, $C_2$ and $C_3$ are associated with error syndromes $S_1$, $S_2$ and $S_3$, while block level check byte $C_0$, is associated with the error syndrome $S_0$.

It should be understood that the subscript numbers assigned to the syndromes, that is $S_0$, $S_1$, etc., are related to the particular T matrix employed to develop the corresponding check characters. Specifically, $S_0$,

which is developed from $C_0$, corresponds to a conventional parity check byte, since each bit position of the word is checked, as shown in Fig. 6. $S_3$, on the other hand, is developed from $C_3$ which is generated in accordance with the logic shown in Fig. 4 that involves multiplying the input byte by a matrix $T^3$. Syndromes $S_1$ and $S_2$, which correspond to check bytes $C_1$ and $C_2$, respectively, are similarly developed using logic which involves matrices $T^1$ and $T^2$, respectively. Such logic for syndrome generation is well known.

Referring again to Fig. 7 for the readback process, block 73 represents the first level ECC function of correcting a single byte error in each of the two interleaved words. A block of data is read from the file and stored in block buffer 74 by sub-blocks. If the error syndromes $S_1$, $S_2$ and $S_3$ for each word of the sub-block are all zeros, then no error has occurred. If all sub-blocks are error-free, then block 75, which generates second level error syndromes (and also data integrity check bytes CR1-CR4), will also indicate an error-free block and the block may be sent to data processing system 70 without any alteration.

If there is a non-zero value for any of the syndromes $S_1$, $S_2$ or $S_3$ which correspond to decoded check bytes $C_1$, $C_2$ or $C_3$, this indicates presence of error at the sub-block level. If the sub-block has only one byte in error at position $i = x$, where $0 < i < m + 1$, the readout bytes $B_i$ can be written as

$$\widetilde{B}_i = \begin{cases} B_i \oplus E_x & \text{at } i = x \\ B_i & \text{at } i \neq x \end{cases}$$

where $E_x$ is an 8-bit error pattern. Then the computed syndromes corresponding to the coding equation (1), (2) and (4) reduce to

$$S_1 = T^x E_x \qquad (6)$$

$$S_2 = T^{2x} E_x \qquad (7)$$

$$S_3 = T^{3x} E_x, \qquad (8)$$

If the one byte error is in check byte $C_3$, then the syndromes reduce to

$$S_1 = S_2 = 0$$
and $S_3 = T^{3x} E_x$.

Thus, the decoding equation is given by

$$\left. \begin{array}{l} E_x = T^{-x} S_1 = T^{-2x} S_2 = T^{-3x} S_3 \text{ if } B_x \text{ is in error} \\ \\ \text{and } 0 = S_1 = S_2 \neq S_3 \text{ if } C_3 \text{ is in error} \end{array} \right\} \quad (9)$$

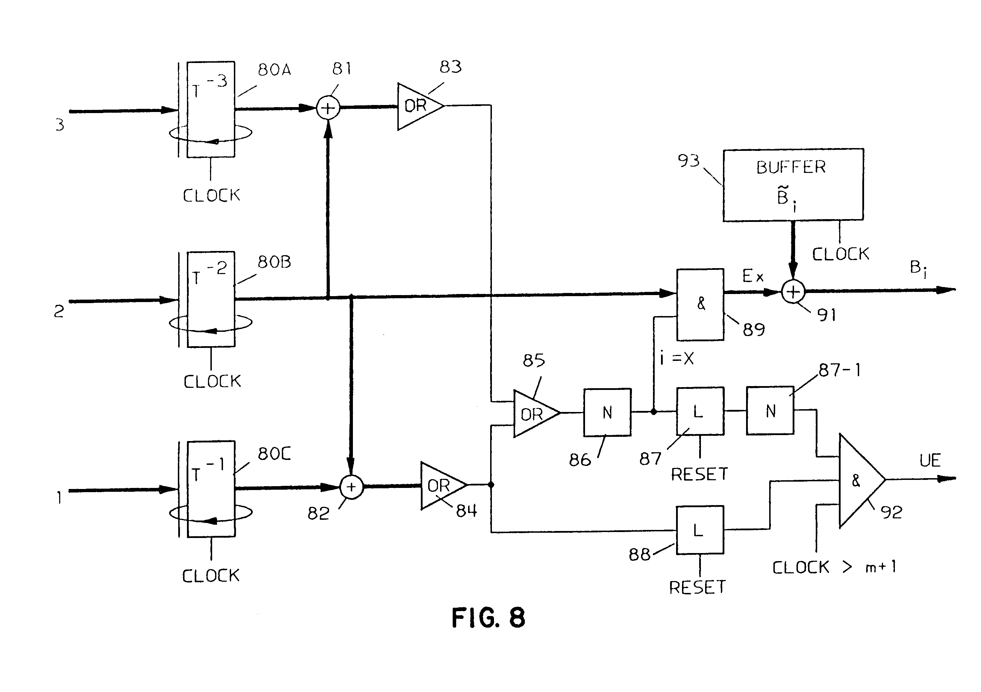

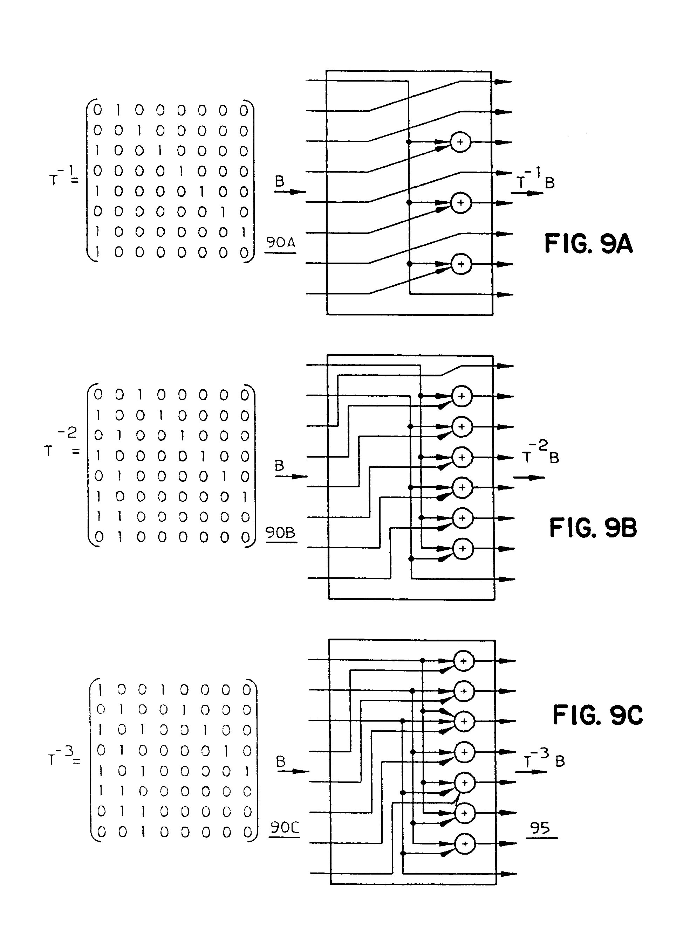

First level (sub-block level) decoder block 73 is illustrated in more detail in Fig. 8. Decoding is accomplished by means of three shift registers 80A, 80B and 80C. The shift registers are similar to the one shown in Fig. 4 except multiplier 33 is different. In particular, shift registers 80A, 80B and 80C are constructed with $T^{-1}$, $T^{-2}$, and $T^{-3}$ multiplier circuits 90A, 90B and 90C, respectively, which are shown in Figs. 9A, 9B and 9C, respectively. The three shift registers are initially loaded with syndromes $S_1$, $S_2$ and $S_3$, respectively. They are shifted with each clock cycle. Each shifting operation multiplies the contents of the three shift registers by $T^{-1}$, $T^{-2}$ and $T^{-3}$, respectively, which is done until the contents of the three shift registers become equal.

With continuing reference to Fig. 8, the logic of blocks 81, 82, 83, 84, 85 and 86 performs the function of comparing the contents of the three shift registers. Blocks 81 and 82 are each an 8 exclusive-OR (Ex-OR) gate. Blocks 83 and 84 are each an 8-way OR gate and block 85 is a 2-way OR gate. Block 86 is a NOT gate. The output of block 86 is a ONE only when the contents of the three shift registers 80A, 80B and 80C become equal. The number of shifts, thus required, determines x and the final contents of each of the three registers is the error pattern $E_x$ in accordance with Equation (9).

Buffer 93 in Fig. 8 holds the readout sub-block bytes, $\tilde{B}_i$, for one sub-block at a time, and delivers them one at a time with each clock cycle starting with $\tilde{B}_0$, in sequence, through $\tilde{B}_{m+1}$. The correction is performed on-the-fly by block 91 (8 Ex-OR gates) using the error pattern, $E_x$, from shift register 80B through 8-way AND gate 89 which is opened by a signal from NOT gate 86 at $i = x$. The corrected bytes are delivered to buffer 74 (Fig. 7) for immediate or later delivery to system 70.

Sub-block level decoder 73 of Fig. 8 will detect the presence of two errors if Equation (9) is not satisfied for any x. Equation (9) is not satisfied if either syndrome $S_1$ or $S_2$ is not zero and also the contents of the three shift registers 80A, 80B and 80C do not become equal for any clock value from 0 to $m + 1$.

Latches 87 and 88 are reset to 0 initially. Latch 88 detects whether $S_1$ or $S_2$ is not zero, and latch 87, with NOT gate 87-1, detects the fact that the contents of the three shift registers have remained unequal. Thus, when the clock count exceeds the value $m + 1$ (i.e., the highest byte position), AND gate 92 provides ON signal, UE, indicating an uncorrected error.

It should be noted that the heavy solid signal lines in Fig. 8 indicate parallel data lines for 8-bit parallel processing.

The corrected bytes produced by the decoder of Fig. 8 are delivered in reverse order relative to the order produced by the encoder of Fig. 3. Such reversed order can be eliminated, if necessary, by suitably modifying the decoder circuits. Decoding can alternatively be accomplished by employing other hardware or software methods.

Referring again to Fig. 7, the syndromes $S_1$, $S_2$, $S_3$ associated with each sub-block are also held in local memory 76 and are retained for further processing at the block level if any sub-block has an uncorrected error as indicated by the UE signal produced by gate 92 of first level decoder 73. Local memory 76 also retains the identification of an uncorrected sub-block as sub-block identifier "f". At the end of the block, the second level syndrome, $S_0$, from block 75 and the first-level syndromes $S_1$, $S_2$, $S_3$ for sub-block f from local memory 76 are processed by second level decoder 78 to correct two errors in sub-block f.

The portion of the system which functions to correct a multibyte error in one sub-block by processing four syndrome bytes corresponding to the four check bytes $C_0$, $C_1$, $C_2$ and $C_3$ can be identical to the "on-the-fly" correction system described in US-A-4,494,234. The specific details of the logic or the detailed steps involved in correcting a two byte error in a sub-block by processing the four syndrome bytes form no part of the present invention, but are available in the above-referenced patent. Other prior art arrangements for correcting two errors in a word by processing four related syndrome bytes may, of course, be employed.

The last error condition that may occur in the system is where one sub-block contains more than two errors and, hence, is uncorrectable. This error condition is beyond the capability of the code selected in this embodiment. Hence, it may be miscorrected. Sometimes this will be indicated by second level decoder 78 when, as a result of processing the block level syndrome bytes, an uncorrectable error signal is provided since the syndrome processing circuitry of block 78 has been unable to identify the location and/or error pattern of one or both errors. The data integrity checks CR1-CR4 will also detect such uncorrected or miscorrected errors.

While the preferred embodiment, as shown and described, assumed the two level code structure in which a one byte error in a codeword was correctable at the first (sub-block) level and a two byte error was correctable at the block level, it should be understood that the method and system may be modified to handle $t_1$ errors at the first (sub-block) level and $t_2$ errors at the block level, where $t_1$ is greater than one and $t_2 > t_1$.

It should be recognised in connection with the system just described that, in order for the correcting process to work at the second level to correct two errors in a sub-block, it is necessary to identify which sub-block contained two one byte errors. In the system described, a sub-block is identified by the non-zero sub-block error syndromes which, when processed by the first-level syndrome processing circuits, indicate an uncorrectable error. If any other sub-block provides non-zero syndromes, which causes the first level syndrome processing circuits to perform a single error correction, this does not interfere with block level correction of the one sub-block with two errors. However, the block level decoder of this embodiment cannot correct three errors in one sub-block or two errors in two sub-blocks.

Thus, in the illustrated embodiment, where each block comprises four sub-blocks, each with two interleaved codewords, the system could correct up to eight one byte errors by the first level decoder, provided that each error was in a different codeword. Also, if one or more codewords in one sub-block contain two one byte errors, then, for the system to correct these errors, all codewords in other sub-blocks in the block must be correctable by the first level decoder.

In general, $t_1$ is the number of errors correctable at the sub block level and $t_2$ is the number of errors correctable at the block level. The combined capabilities of the two levels can provide correction of various combinations of multibyte errors distributed over many sub-blocks. This is described in more detail in the following.

As stated earlier in this specification, each sub-block consists of m data bytes and $r_1$ check bytes. Each sub-block comprises a codeword from a code having minimum Hamming distance of $d_1$ symbol positions, where the symbols (i.e., bytes) are elements of Galois Field $(GF(2^b))$. The Hamming distance between two codewords is defined to be the number of symbol positions in which the word symbols differ.

Each block consists of n sub-blocks and $r_2$ check bytes which are common to all its sub-blocks. The data part of the block level code can be viewed as one sub-block having modulo-2 superposition of n sub-block codewords. Then the $r_2$ check bytes (either independently or along with the superpositioned $r_1$ check bytes of all sub-blocks) provide a minimum Hamming distance of $d_2$ (over one sub-block) at the block level, where $d_2 > d_1$.

The decoding process provides correction of up to $t_1$ errors and detection of up to $t_1 + c$ errors in each sub-block, where $d_1 \geq (2t_1 + c + 1)$. Unless the number of errors in a sub-block exceeds the error correcting capability at that level and such errors are either left uncorrected or are miscorrected, no further correction at the block level is required. Uncorrected or miscorrected errors at the sub-block level are corrected at the block level. If all errors are confined to one sub-block, the block level code will provide correction of up to $t_2$ errors, where $d_2 \geq (2t_2 + 1)$. However, many combinations of errors in other sub-blocks are also correctable.

The combined error correction capability of the two level coding error correction system described further provides correction of any combination of $t_1 + x$ errors in any one of the sub-blocks, and up to $t_1$ errors in any or all of the other sub-blocks. For this further capability, x represents the number of excess errors in any one sub-block and is any positive integer such that

$t_1 + x \leq t_2$, and

$x \leq c$.

Also, when $t_1 + x \leq t_2$ and $x > c$, the system described provides correction of any combination of $t_1 + x$ errors in any one of the sub-blocks and up to $t_1 + c - x$ errors in any or all of the other sub-blocks using the combined, first and second level capability. However, in this case, the sub-block having $t_1 + x$ errors may be miscorrected at the first level, but identified for second level correction whenever the block level syndromes are non-zero. The sub-block is identified by the fact that it has the highest number of corrections compared to the number of corrections in any other of the sub-blocks of the codeword. The identified sub-block is corrected at the second level in the manner described for the case of a miscorrected sub-block in US-A-4,494,234.

Table I summarises typical parameters of the error correction system described, extended to show correction of more errors at the first and second levels. The table shows the capability for correcting up to $t_1 = 3$ and $t_2 = 6$ errors.

TABLE 1

| | Config Parameters | | | Error Correction Capability (a,b) | | |
|---|---|---|---|---|---|---|
| | $t_1$ | $t_2$ | c | 1st Level | 2nd Level( * ) | 2nd Level( ** ) |
| I | 1 | 2 | 1 | (1,1) | (2,1) | |
| II | 2 | 3 | 1 | (2,2) | (3,2) | |
| III | 2 | 4 | 1 | (2,2) | (3,2) | (4,1) |
| IV | 3 | 5 | 1 | (3,3) | (4,3) | (5,1) |
| V | 3 | 6 | 1 | (3,3) | (4,3) | (5,2) |
| | | | | | | (6,1) |
| VI | 3 | 6 | 2 | (3,3) | (4,3) | (6,2) |
| | | | | | (5,3) | |

(*) without miscorrection at the first level
(**) with miscorrection at the first level

Error correction capability (a,b) refers to correction of any combination of up to "a" errors in any one of the sub-blocks, and up to "b" errors in any or all of the remaining sub-blocks.

It should be noted that, if there are any errors, y, in the block level error check bytes, then the second level error correction capability, $t_2$, is commensurately reduced by y. Thus, in that event, $t_1 + x + y \leq t_2$.

The sub-block level error syndromes are decoded by the sub-block level decoder for up to $t_1$ errors in each sub-block and the errors are corrected on-the-fly. Thus, when x = 0, all sub-block errors are corrected properly since they are all within the capability of the sub-block level code.

When $x \leq c$, then the sub-block level decoder will detect and identify a sub-block having $t_1 + x$ errors without either correcting or miscorrecting such errors. This sub-block will be identified by its number f. The errors are then corrected at the second level.

When x > c, the sub-block level decoder may miscorrect a sub-block having $t_1 + x$ errors by altering at least $(t_1 + c + 1 - x)$ byte positions, since the nearest codeword must differ from the received codeword in at least $(t_1 + c + 1 - x)$ positions for a minimum Hamming distance of $d_1$, where $d_1$ is given by $d_1 = 2t_1 + c + 1$. In contrast, the decoder will alter up to $(t_1 + c - x)$ byte positions in any of the other sub-blocks, all of which will be corrected properly at the sub-block level. The number of alterations in the miscorrected sub-block, in such case, exceeds those in any other sub-block by at least one. This identifies sub-block f having $t_1 + x$ errors uniquely. Alternatively, the decoder may find sub-block f uncorrectable <u>a priori</u> and leave it unaltered.

The sub-block level data, after first level error correction, is used in the computation of the block level error syndrome set, {S}. The set {S} is then the syndrome set for all errors still present in the block, including sub-block errors $(t_1 + x)$, block level check byte errors, y, and up to $t_1$ alterations, if any. The total of $2t_1 + x + y$ is less than the minimum Hamming distance, $d_2$, at the block level since $t_1 + x + y \leq t_2$ and $d_2$ is given by $d_2 = (2t_2 + 1)$. Thus, any uncorrected errors and alterations will be detected at the block level by {S} $\neq 0$.

Sub-block f, with $(t_1 + x)$ errors, is uniquely identified during processing of sub-block syndromes from the fact that it was declared uncorrectable or the number of corrections in sub-block f exceeded those in any of the other sub-blocks by at least 1. If all sub-blocks were corrected properly at the sub-block level, then the value of f is of no consequence at the block level.

Let $\{S_f\}$ denote the block level error syndromes due to the error patterns (i.e., miscorrections) introduced by the decoder in sub-block f. Such error patterns can be removed from sub-block f and their contribution $\{S_f\}$ from the syndrome {S}. Thus, the set $\{S\} - \{S_f\}$ represents the syndromes for the original $(t_1 + x)$ errors in sub-block f and y errors in the block level check bytes. The subtraction - is the same as the addition + in modulo 2 arithmetic which is accomplished by the conventional bit-by-bit exclusive-OR logic function. This part of the error correction system is not shown in Fig. 7 and is implemented in the manner described for the case of a miscorrected sub-block in US-A-4,494,234. Note that syndromes {S} and $\{S_f\}$ are all known quantities. The block level decoding of $\{S\} - \{S_f\}$ for $t_2$ errors provides proper correction of all remaining errors.

## Claims

1. An error correcting system for correcting errors in coded data recorded on a record medium (11) in blocks (12) of data bytes, in which each block comprises at least one sub-block (14), of data bytes (B2 - B49) and at least one error check byte (C1 - C3), and at least one block error check byte,

said system comprising

error syndrome byte generating means, responsive to the error check bytes recorded in each sub-block, for generating, during read out of the data bytes and error check bytes in each sub-block, error syndrome bytes, and

error correcting means, responsive to said error syndrome bytes, for correcting errors in the data bytes read out from each of said sub-blocks,

first error syndrome byte generating means for generating sub-block error syndrome bytes, corresponding to the check bytes associated with each sub-block,

first error syndrome processing circuitry (73), responsive to said sub-block error syndrome bytes, to detect and correct a predetermined number of errors in the data bytes in each sub-block and to detect but not correct another predetermined number of errors in the data bytes in each sub-block,

block error check byte generating means (72B) for generating block error check bytes (CO) for each block,

second error syndrome byte generating means for generating block error syndrome bytes, corresponding to the error check bytes in each block and said block error check bytes, and

second error syndrome processing circuitry (74 - 78), responsive to said block error syndrome bytes, to correct additional errors in the data bytes in each block,

characterised in that

each sub-block comprises up to $2^b$ b-bit data bytes, where b is any positive integer and $(2t_1 + c)$ error check bytes where $t_1$ and c are positive integers such that $t_1 \geq c \geq 1$, and

each block comprises up to $2t_2$ b-bit error check bytes where $t_2$ is a positive integer such that $t_2 > t_1$,

said first error syndrome byte generating means generates, for each sub-block, $(2t_1 + c)$ error syndrome bytes, each containing b bits, corresponding to said $(2t_1 + c)$ error check bytes in each sub-block,

said first error syndrome processing circuitry detects and corrects up to $t_1$ errors and detects but does not correct up to $(t_1 + c)$ errors in each sub-block, and

said second error syndrome generating means generates, for each block, $2t_2$ block error syndrome bytes.

2. An error correction system as claimed in claim 1 characterised in that it will correct up to $t_1$ errors in each sub-block by processing said $(2t_1 + c)$ error syndrome bytes in said first error syndrome processing circuitry and up to $(t_1 + x)$ errors in one sub-block by processing said $2t_2$ error syndrome bytes in said second error syndrome processing circuitry where x is a non-negative integer such that $(t_1 + x) \leq t_2$ and $x \leq c$.

3. An error correction system as claimed in claim 1 characterised in that it will correct up to $(t_1 + c - x)$ errors in each sub-block by processing said $2t_1 + c$ syndrome bytes in said first error syndrome processing circuitry and up to $(t_1 + x)$ errors in one sub-block by processing said $2t_2$ error syndrome bytes in said second error syndrome processing circuitry, where x is a non-negative integer such that $(t_1 + x) \leq t_2$ and $x \leq c$.

4. An error correcting system as claimed in any one of the preceding claims characterised in that said second error syndrome byte generating means comprises a sub-block buffer for storing the data bytes of each sub-block as they are read out and for storing error data developed by said first error syndrome processing circuitry for said sub-block as a result of processing said $(2t_1 + c)$ error syndrome bytes.

5. An error correcting system as claimed in any one of the preceding claims 1 to 3 characterised in that said second error syndrome byte generating means operates to identify any sub-block which cannot be corrected utilising its associated error check bytes.

6. An error correcting system as claimed in claim 5 characterised in that second error syndrome byte generating means operates to identify the sub-block requiring the largest number of byte corrections.

7. A method of correcting errors in coded data recorded on a record medium (11) in blocks (12) of data bytes, in which each block comprises at least one sub-block (14), of data bytes (B2-B49) and at least one sub-block error check byte (C1-C3), and at least one block error check byte,

said method comprising

generating, in response to the error check bytes recorded in each sub-block, during read out of the data bytes and error check bytes in each sub-block, error syndrome bytes, and

correcting, in response to said error syndrome bytes, errors in the data bytes read out from each of said sub-blocks,

generating sub-block error syndrome bytes, corresponding to the check bytes associated with each sub-block, in response to said sub-block error syndrome bytes, detecting and correcting a predetermined number of errors in the data bytes in each sub-block and detecting but not correcting another predetermined number of errors in the data bytes in each sub-block,

generating block error check bytes for each block

generating block error syndrome bytes corresponding to the error check bytes in each block and said block error check bytes, and

correcting, in response to said block error syndrome bytes, additional errors in the data bytes in each block,

characterised in that

each sub-block comprises up to $2^b$ b-bit data bytes, where b is any positive integer,

each sub-block comprises $(2t_1 + c)$ error check bytes where $t_1$ and c are positive integers such that $t_1 \geq c \geq 1$, and

each block comprises up to $2t_2$ b-bit error check bytes where $t_2$ is a positive integer such that $t_2 > t_1$,

and in that said method comprises

generating for each sub-block, $(2t_1 + c)$ error syndrome bytes, each containing b bits, corresponding to said $(2t_1 + c)$ error check bytes in each sub-block,

detecting and correcting up to $t_1$ errors in and detecting but not correcting up to $(t_1 + c)$ errors in each sub-block, and

generating, for each block, $2t_2$ block error syndrome bytes.

**Revendications**

1. Système correcteur d'erreurs pour corriger des erreurs dans des données codées enregistrées en blocs (12) de multiplets de données sur un support d'enregistrement (11), dans lequel chaque bloc comprend au moins un sous-bloc (14) de multiplets de données (B2 - B49), au moins un multiplet de contrôle d'erreurs de sous-bloc (C1 - C3) et au moins un multiplet de contrôle d'erreurs de bloc,

système qui comprend

un moyen générateur de multiplets de syndrome d'erreur, sensible aux multiplets de contrôle d'erreurs enregistrés dans chaque sous-bloc, pour générer, pendant la lecture ou extraction des multiplets de données et des multiplets de contrôle d'erreurs dans chaque sous-bloc, des multiplets de syndrome d'erreur, et

un moyen correcteur d'erreurs, sensible à ces multiplets de syndrome d'erreur, pour corriger des erreurs dans les multiplets de données extraits de chacun des sous-blocs,

un premier moyen générateur de multiplets de syndrome d'erreur pour générer des multiplets de syndrome d'erreur de sous-bloc correspondant aux multiplets de contrôle coordonnés à chaque sous-

EP 0 218 413 B1

bloc,

une première circuiterie de traitement de syndromes d'erreur (73), sensible aux multiplets de syndrome d'erreur de sous-bloc, pour détecter et corriger un nombre prédéterminé d'erreurs dans les multiplets de données dans chaque sous-bloc et pour détecter, mais ne pas corriger, un autre nombre prédéterminé d'erreurs dans les multiplets de données dans chaque sous-bloc.

un moyen générateur de multiplets de contrôle d'erreurs de bloc (72B) pour générer des multiplets de contrôle d'erreurs de bloc (CO) pour chaque bloc,

un second moyen générateur de multiplets de syndrome d'erreur pour générer des multiplets de syndrome d'erreur de bloc, correspondant aux multiplets de contrôle d'erreurs dans chaque bloc et auxdits multiplets de contrôle d'erreurs de bloc, et

une seconde circuiterie de traitement de syndromes d'erreur (74 - 78), sensible aux multiplets de syndrome d'erreur de bloc, pour corriger des erreurs additionnelles dans les multiplets de données dans chaque bloc,

caractérisé en ce que

chaque sous-bloc comprend jusqu'à $2^b$ multipletsde données à b bits, b étant un entier positif quelconque, et $(2t_1 + c)$ multiplets de contrôle d'erreurs, $t_1$ et c étant des entiers positifs tels que $t_1 \geq c \geq 1$,et

chaque bloc comprend jusqu'à $2t_2$ multiplets de contrôle d'erreurs à b bits, $t_2$ étant un entier positif tel que $t_2 > t_1$,

le premier moyen générateur de multiplets de syndrome d'erreur génère, pour chaque sous-bloc, $(2t_1 + c)$ multiplets de syndrome d'erreur, contenant chacun b bits, correspondant aux $(2t_1 + c)$ multiplets de contrôle d'erreurs dans chaque sous-bloc,

la première circuiterie de traitement de syndromes d'erreur détecte et corrige jusqu'à $t_1$ erreurs et détecte, mais ne corrige pas, jusqu'à $(t_1 + c)$ erreurs dans chaque sous-bloc, et

le second moyen générateur de multiplets de syndrome d'erreur génère, pour chaque bloc, $2t_2$ multiplets de syndrome d'erreur de bloc.

2. Système correcteur d'erreurs selon la revendication 1, caractérisé en ce qu'il corrigera jusqu'à $t_1$ erreurs dans chaque sous-bloc en traitant les $(2t_1 + c)$ multiplets de syndrome d'erreur dans la première circuiterie de traitement de syndromes d'erreur et jusqu'à $(t_1 + x)$ erreurs dans un sous-bloc en traitant les $2t_2$ multiplets de syndrome d'erreur dans la seconde circuiterie de traitement de syndromes d'erreur, où x est un entier non-négatif tel que $(t_1 + x) \leq t_2$ et $x \leq c$.

3. Système correcteur d'erreurs selon la revendication 1, caractérisé en ce qu'il corrigera jusqu'à $(t_1 + c - x)$ erreurs dans chaque sous-bloc en traitant les $2t_1 + c$ multiplets de syndrome dans la première circuiterie de traitement de syndromes d'erreur et jusqu'à $(t_1 + x)$ erreurs dans un sous-bloc en traitant les $2t_2$ multiplets de syndrome d'erreur dans la seconde circuiterie de traitement de syndromes d'erreur, où x est un entier non-négatif tel que $(t_1 + x) \leq t_2$ et $x \leq c$.

4. Système correcteur d'erreurs selon l'une quelconque des revendications précédentes, caractérisé en ce que le second moyen générateur de multiplets de syndrome d'erreur comprend un tampon de sous-blocs pour mémoriser les multiplets de données de chaque sous-bloc lorsqu'ils sont extraits et pour mémoriser des données d'erreur créées par la première circuiterie de traitement de syndromes d'erreur pour ce sous-bloc par suite du traitement des $(2t_1 + c)$ multiplets de syndrome d'erreur.

5. Système correcteur d'erreurs selon l'une quelconque des revendications 1 à 3 précédentes, caractérisé en ce que le second moyen générateur de multiplets de syndrome d'erreur effectue l'identification de tout sous-bloc qui ne peut pas être corrigé en utilisant les multiplets de contrôle d'erreurs qui lui sont

13

EP 0 218 413 B1

coordonnés.

**6.** Système correcteur d'erreurs selon la revendication 5, caractérisé en ce que le second moyen générateur de multiplets de syndrome d'erreur effectue l'identification du sous-bloc demandant le plus grand nombre de corrections de multiplet.

**7.** Procédé pour corriger des erreurs dans des données codées enregistrées en blocs (12) de multiplets de données sur un support d'enregistrement (11), dans lequel chaque bloc comprend au moins un sous-bloc (14) de multiplets de données (B2 - B49), au moins un multiplet de contrôle d'erreurs de sous-bloc (C1 - C3) et au moins un multiplet de contrôle d'erreurs de bloc,

procédé qui comprend

la génération de multiplets de syndrome d'erreur en réponse aux multiplets de contrôle d'erreurs enregistrés dans chaque sous-bloc pendant l'extraction des multiplets de données et des multiplets de contrôle d'erreurs dans chaque sous-bloc, et

la correction, en réponse à ces multiplets de syndrome d'erreur, d'erreurs contenues dans les multiplets de données extraits de chacun des sous-blocs,

la génération de multiplets de syndrome d'erreur de sous-bloc, correspondant aux multiplets de contrôle coordonnés à chaque sous-bloc,

en réponse à ces multiplets de syndrome d'erreur de sous-bloc, la détection et la correction d'un nombre prédéterminé d'erreurs dans les multiplets de données dans chaque sous-bloc et la détection, mais non pas la correction, d'un autre nombre prédéterminé d'erreurs dans les multiplets de données dans chaque sous-bloc,

la génération de multiplets de contrôle d'erreurs de bloc pour chaque bloc,

la génération de multiplets de syndrome d'erreur de bloc correspondant aux multiplets de contrôle d'erreurs dans chaque bloc et auxdits multiplets de contrôle d'erreurs de bloc, et

la correction d'erreurs additionnelles dans les multiplets de données dans chaque bloc en réponse à ces multiplets de syndrome d'erreur de bloc,

caractérisé en ce que

chaque sous-bloc comprend jusqu'à $2^b$ multipletsde données à b bits, b étant un entier positif quelconque,

chaque sous-bloc comprend $(2t_1 + c)$ multiplets de contrôle d'erreurs, $t_1$ et c étant des entiers positifs tels que $t_1 \geq c \geq 1$ et

chaque bloc comprend jusqu'à $2t_2$ multiplets de contrôle d'erreurs à b bits, $t_2$ étant un entier positif tel que $t_2 > t_1$,

et en ce que le procédé comprend

la génération, pour chaque sous-bloc, de $(2t_1 + c)$ multiplets de syndrome d'erreur, contenant chacun b bits, correspondant auxdits $(2t_1 + c)$ multiplets de contrôle d'erreurs dans chaque sous-bloc,

la détection et la correction d'un nombre d'erreurs allant jusqu'à $t_1$ dans chaque sous-bloc, de même que la détection mais non pas la correction d'un nombre d'erreurs allant jusqu'à $(t_1 + c)$ dans chaque sous-bloc, et

la génération de $2t_2$ multiplets de syndrome d'erreur de bloc pour chaque bloc.

14

EP 0 218 413 B1

**Patentansprüche**

1. Fehlerkorrektursystem zum Korrigieren von Fehlern in codierten Daten, die auf einem Aufzeichnungsmedium (11) in Blöcken (12) von Datenbytes aufgezeichnet sind, bei welchen jeder Block zumindest einen Unterblock (14) aus Datenbytes (B2-B49) und zumindest einem Fehlerprüfbyte (C1-C3) und zumindest ein Fehlerprüfbyte für einen Block aufweist,

wobei das System folgendes aufweist:

Mittel zum Erzeugen von Fehlersyndrombytes, die auf die in jedem Unterblock aufgezeichneten Fehlerprüfbytes ansprechen, um während des Auslesens der Datenbytes und der Fehlerprüfbytes in jedem Unterblock Fehlersyndrombytes zu erzeugen und

Fehlerkorrekturmittel, die auf die Fehlersyndrombytes ansprechen, um Fehler in den aus jedem der Unterblöcke ausgelesenen Datenbytes zu korrigieren,

ein erstes Mittel zum Erzeugen von Fehlersyndrombytes, um Fehlersyndrombytes für einen Unterblock zu erzeugen, welche den jedem Unterblock zugeordneten Prüfbytes entsprechen,

eine erste Verarbeitungsschaltung (73) für ein Fehlersyndrom, die auf die Fehlersyndrombytes für einen Unterblock ansprechen, um eine vorbestimmte Anzahl von Fehlern in den Datenbytes in jedem Unterblock zu erfassen und zu korrigieren und um eine andere vorbestimmte Anzahl von Fehlern in den Datenbytes in jedem Unterblock zu erfassen, jedoch nicht zu korrigieren,

Mittel (72B) zum Erzeugen von Fehlerprüfbytes für einen Block, um für jeden Block Fehlerprüfbytes (CO) für einen Block zu erzeugen,

ein zweites Mittel zum Erzeugen von Fehlersyndrombytes, um Fehlersydrombytes für einen Block zu erzeugen, welche den Fehlerprüfbytes in jedem Block und den Fehlerprüfbytes für einen Block entsprechen und

eine zweite Verarbeitungsschaltung (74-78) für ein Fehlersyndrom, die auf die Fehlersyndrombytes für einen Block anspricht, um zusätzliche Fehler in den Datenbytes in jedem Block zu korrigieren,

dadurch gekennzeichnet, daß

jeder Unterblock bis zu $2^b$ Datenbytes mit b Bits, wo b irgendeine positive ganze Zahl ist, und $(2t_1 + c)$ Fehlerprüfbytes aufweist, wo $t_1$ und c positive ganze Zahlen sind, für die $t_1 \geq c \geq 1$ und

jeder Block bis zu $2t_2$ Fehlerprüfbytes mit b Bits aufweist, wo $t_2$ eine positive ganze Zahl ist, für die $t_2 > t_1$,

das erste Mittel zum Erzeugen eines Fehlersyndrombytes $(2t_1 + c)$ Fehlersyndrombytes für jeden Unterblock erzeugt, wobei jedes b Bits enthält, welche den $(2t_1 + c)$ Fehlerprüfbytes in jedem Unterblock entsprechen,

die erste Verarbeitungsschaltung für ein Fehlersyndrom bis zu $t_1$ Fehlern erfaßt und korrigiert und bis zu $(t_1 + c)$ Fehlern in jedem Unterblock erfaßt, jedoch nicht korrigiert und

das zweite Mittel zum Erzeugen eines Fehlersyndroms $2t_2$ Fehlersyndrombytes für jeden Block erzeugt.

2. Fehlerkorrektursystem nach Anspruch 1, dadurch gekennzeichnet, daß dieses bis zu $t_1$ Fehlern in jedem Unterblock durch Verarbeiten der $(2t_1 + c)$ Fehlersyndrombytes in der ersten Verarbeitungsschaltung für ein Fehlersyndrom und bis zu $(t_1 + x)$ Fehlern in einem Unterblock durch Verarbeiten der $2t_2$ Fehlersyndrombytes in der zweiten Verarbeitungsschaltung für ein Fehlersyndrom korrigiert wird, wo x eine nicht-negative ganze Zahl ist, für die $(t_1 + x) \leq t_2$ und $x \leq c$.

15

**3.** Fehlerkorrektursystem nach Anspruch 1, dadurch gekennzeichnet, daß dieses bis zu $(t_1 + c - x)$ Fehlern in jedem Unterblock durch Verarbeiten der $2t_1 + c$ Syndrombytes in der ersten Verarbeitungsschaltung für ein Fehlersyndrom und bis zu $(t_1 + x)$ Fehlern in einem Unterblock durch Verarbeiten der $2t_2$ Fehlersyndrombytes in der zweiten Verarbeitungsschaltung für ein Fehlersyndrom korrigieren wird, wo x eine nicht-negative Zahl ist, für die $(t_1 + x) \leq t_2$ und $x \leq c$.

**4.** Fehlerkorrektursystem nach irgend einem der vorgehenden Ansprüche, dadurch gekennzeichnet, daß das zweite Mittel zum Erzeugen eines Fehlersyndrombytes einen Unterblockpuffer aufweist, um die Datenbytes jedes Unterblocks zu speichern, wenn sie ausgelesen werden, und um Fehlerdaten zu speichern, die von der ersten Verarbeitungsschaltung für ein Fehlersyndrom für den Unterblock infolge des Verarbeitens der $(2t_1 + c)$ Fehlersyndrombytes erzeugt werden.

**5.** Fehlerkorrektursystem nach irgend einem der vorgehenden Ansprüche 1 bis 3, dadurch gekennzeichnet, daß das zweite Mittel zum Erzeugen eines Fehlersyndroms arbeitet um irgendeinen Unterblock zu identifizieren, der unter Verwendung seiner zugeordneten Fehlerprüfbytes nicht korrigiert werden kann.

**6.** Fehlerkorrektursystem nach Anspruch 5, dadurch gekennzeichnet, daß das zweite Mittel zum Erzeugen von Fehlersyndrombytes arbeitet, um den Unterblock zu identifizieren, welcher die größte Anzahl von Bytekorrekturen erfordert.

**7.** Verfahren zum Korrigieren von Fehlern in codierten Daten, die auf einem Aufzeichnungsmedium (11) in Blöcken (12) von Datenbytes aufgezeichnet sind, bei welchen jeder Block zumindest einen Unterblock (14) aus Datenbytes (B2-B49) und zumindest einem Fehlerprüfbyte (C1-C3) für einen Unterblock und zumindest ein Fehlerprüfbyte für einen Block aufweist,

wobei das Verfahren folgendes umfaßt:

Erzeugen von Fehlersyndrombytes entsprechend den in jedem Unterblock aufgezeichneten Fehlerprüfbytes während des Auslesens der Datenbytes und der Fehlerprüfbytes in jedem Unterblock und Korrigieren von Fehlern in den aus jedem der Unterblöcke ausgelesenen Datenbytes entsprechend den Fehlersyndrombytes,

Erzeugen von Fehlersyndrombytes für einen Unterblock, welche den jedem Unterblock zugeordneten Prüfbytes entsprechen,

entsprechend den Fehlersyndrombytes für einen Unterblock Erfassen und Korrigieren einer vorbestimmten Anzahl von Fehlern in den Datenbytes in jedem Unterblock und Erfassen, jedoch nicht Korrigieren einer anderen vorbestimmten Anzahl von Fehlern in den Datenbytes in jedem Unterblock,

Erzeugen von Fehlerprüfbytes für einen Block für jeden Block,

Erzeugen von Fehlersyndrombytes für einen Block, welche den Fehlerprüfbytes in jedem Block und den Fehlerprüfbytes für einen Block entsprechen und

Korrigieren von zusätzlichen Fehlern in den Datenbytes in jedem Block entsprechend den Fehlersyndrombytes für einen Block,

dadurch gekennzeichnet, daß

jeder Unterblock bis zu $2^b$ Datenbytes mit b Bits aufweist, wo b irgendeine positive ganze Zahl ist,

jeder Unterblock $(2t_1 + c)$ Fehlerprüfbytes aufweist, wo $t_1$ und c positive ganze Zahlen sind, für die $t_1 \geq c \geq 1$ und

jeder Block bis zu $2t_2$ Fehlerprüfbytes mit b Bits aufweist, wo $t_2$ eine positive ganze Zahl ist, für die $t_2 > t_1$,

und daß das Verfahren folgendes umfaßt:

Erzeugen von $(2t_1 + c)$ Fehlersyndrombytes für jeden Unterblock, wobei jedes b Bits enthält, welche den $(2t_1 + c)$ Fehlerprüfbytes in jedem Unterblock entsprechen,

Erfassen und Korrigieren bis zu $t_1$ Fehlern und Erfassen, jedoch nicht Korrigieren bis zu $(t_1 + c)$ Fehlern in jedem Unterblock und

Erzeugen von $2t_2$ Fehlersyndrombytes für jeden Block.

FIG. 1

FIG. 2

FIG. 3

FIG. 4

FIG. 6

$$T^3 = \begin{pmatrix} 0 & 0 & 0 & 0 & 0 & 1 & 1 & 1 \\ 0 & 0 & 0 & 0 & 0 & 0 & 1 & 1 \\ 0 & 0 & 0 & 0 & 0 & 0 & 0 & 1 \\ 1 & 0 & 0 & 0 & 0 & 1 & 1 & 1 \\ 0 & 1 & 0 & 0 & 0 & 0 & 1 & 1 \\ 0 & 0 & 1 & 0 & 0 & 1 & 1 & 0 \\ 0 & 0 & 0 & 1 & 0 & 1 & 1 & 0 \\ 0 & 0 & 0 & 0 & 1 & 1 & 1 & 0 \end{pmatrix} \begin{matrix} 51 \\ 52 \\ 53 \\ 54 \\ 55 \\ 56 \\ 57 \\ 58 \end{matrix}$$

COL. 0 1 2 3 4 5 6 7

FIG. 5

DATA PROCESSING SYSTEM — 70

WRITE DATA

ECC ENCODER — 72

$C_1C_2C_3$

$C_0, CR_1-CR_4$

SUBBLOCK FORMATTER — 72A

BLOCK FORMATTER — 72B

DISK STORAGE — 71

READ DATA

FIRST LEVEL DECODER — 73

FIRST LEVEL CORRECTED DATA

LOCAL MEMORY — SUBBLOCK IDENTIFIER f SYNDROMES $S_1S_2S_3$ — 76

BUFFER SUBBLOCKS 1 TO n — 74

SUBBLOCK f MODIFIER — 78

SECOND LEVEL CHECK SYNDROMES {S} — 75

{S} = 0 BLOCK O.K.

$S_0$

$S_1S_2S_3$

SECOND LEVEL DECODER — 78

SECOND LEVEL MODIFICATIONS FOR SUBBLOCK f

FIG. 7

FIG. 8

EP 0 218 413 B1

FIG. 9A

FIG. 9B

FIG. 9C